# EUROPEAN PATENT SPECIFICATION

(11) **EP 4 362 075 B1**
(45) Date of publication and mention of the grant of the patent: **30.04.2025**
(21) Application number: 22203696.4
(22) Date of filing: 25.10.2022
(51) Int. Cl.: H01L 21/8234, H01L 21/768, H01L 23/528, H01L 23/535

(54) **A METHOD FOR INTERCONNECTING A BURIED WIRING LINE AND A SOURCE/DRAIN BODY**
VERFAHREN ZUR VERBINDUNG EINER VERGRABENEN VERBINDUNGSLEITUNG UND EINES SOURCE/DRAIN-KÖRPERS
PROCÉDÉ D'INTERCONNEXION D'UNE LIGNE DE CÂBLAGE ENTERRÉE ET D'UN CORPS DE SOURCE/DRAIN

(43) Date of publication of application: 01.05.2024
(73) Proprietor: IMEC VZW, 3001 Leuven (BE)
(72) Inventor: CHAN, Boon Teik, 3012 Wilsele (BE); MERTENS, Hans, 3000 Leuven (BE); TOKEI, Zsolt, 3000 Leuven (BE); HORIGUCHI, Naoto, 3000 Leuven (BE)
(74) Representative: AWA Sweden AB

(56) References cited:
- US-A1- 2015 380 250
- US-A1- 2020 373 331
- US-A1- 2022 130 761
- US-B1- 10 832 964

## Description

### Technical field

The present disclosure relates to a method for interconnecting a buried wiring line and a source/drain body.

### Background

Integrated circuits typically comprise power rails (for example for VSS and VDD supply voltage distribution). Traditionally, power rails have been encapsulated within a back-end-of-line (BEOL) interconnect structure located above the level of the active physical devices (such as transistors). Current advanced technology nodes may in contrast be provided with a "buried" power rail (BPR) which may be formed in a trench in the substrate, such that the power rail may be located at a level below the active physical devices. Burying power rails enables the cross-section of the power rails to be increased (for example reducing the line resistance) without occupying valuable space in the BEOL interconnect structure. Additionally, BPRs may facilitate design of reduced track height standard cells by allowing neighbouring circuit cells to share a common (e.g. increased cross-section) BPR.

A BPR and a source/drain body of an adjacent horizontal channel transistor (e.g. a finFET, or a nanosheet- or nanowire-FET) may be interconnected by forming a via-like metal contact on the source/drain body and extending therefrom to land on the BPR. This interconnect is also known as a via-to-BPR (VBPR). Forming the metal contact typically involves high aspect ratio etching through inter-layer dielectric, liner layers and/or capping layers within narrow contact trenches between gates, with entailing challenges during metal filling. The further aggressive scaling and drive towards high aspect ratio device structures make these issues increasingly challenging.

US 2020/373331 A1 discloses an integrated circuit device including an embedded insulation layer, a semiconductor layer on the embedded insulation layer, the semiconductor layer having a main surface, and a plurality of fin-type active areas protruding from the main surface to extend in a first horizontal direction and in parallel with one another, a separation insulation layer separating the semiconductor layer into at least two element regions adjacent to each other in a second horizontal direction intersecting the first horizontal direction, source/drain regions on the plurality of fin-type active areas, a first conductive plug on and electrically connected to the source/drain regions, a buried rail electrically connected to the first conductive plug while penetrating through the separation insulation layer and the semiconductor layer, and a power delivery structure arranged in the embedded insulation layer, the power delivery structure being in contact with and electrically connected to the buried rail.

### Summary

In light of the above, it is an objective to provide an improved method for interconnecting a buried wiring line and a source/drain body, at least partly addressing the afore-mentioned challenges. Further and alternative objectives may be understood from the following.

<The invention is defined by the claims. There> is provided a method for interconnecting a buried wiring line and a source/drain body, the method comprising:
forming a fin structure on a substrate, the fin structure comprising at least one channel layer;
forming a buried wiring line in a trench extending alongside the fin structure, wherein the buried wiring line is capped by a first insulating layer structure;
forming a source/drain body on the at least one channel layer by epitaxy;
forming a via hole in the first insulating layer structure to expose an upper surface of the buried wiring line;
forming a metal via in the via hole;
forming a second insulating layer structure over the first insulating layer structure, wherein a contact opening is defined in the second insulating layer structure to expose the source/drain body and an upper via portion of the metal via; and
forming a source/drain contact in the contact opening, on the upper via portion and the source/drain body, thereby interconnecting the buried wiring line and the source/drain body.

The method facilitates forming of an interconnection between a buried wiring line and a source/drain body. The forming of the via hole and the metal via therein may be referred to as a metal via "prefill", wherein the interconnection is completed by subsequently forming the source/drain contact on the prefill and the source/drain body. The method thereby reduces the required depth for the contact opening since the contact opening need only extend to a sufficient depth for exposing the upper via portion of the metal via / prefill. This additionally facilitates a void free metal filling as less height needs to be filled during the source/drain contact formation.

The term "fin structure" as used herein refers to a fin-shaped structure with a longitudinal dimension oriented in a horizontal direction (e.g. a "first" horizontal direction) along the substrate and protruding vertically therefrom.

The fin structure may comprise a single channel layer integrally formed with the fin structure (wherein the fin structure may be a single fin-shaped semiconductor body). The fin structure may however also comprise one or more horizontally oriented channel layers stacked over a base portion of the fin structure protruding from the substrate.

Relative spatial terms such as "vertical", "upper", "lower", "top", "bottom", "above", "under", "below", are herein to be understood as denoting locations or orientations within a frame of reference of the substrate. In particular, the terms may be understood as locations or orientations along a normal direction to the substrate (i.e. a main plane of extension of the substrate). Correspondingly, terms such as "lateral" and "horizontal" are to be understood as locations or orientations parallel to the substrate (i.e. parallel to the main plane of extension of the substrate).

In some embodiments, the buried wiring line may be a BPR. The method is however applicable to also other types of buried wiring lines.

In some embodiments, the metal via may be formed such that the upper via portion of the metal via protrudes above the via hole in the first insulating layer structure. The metal via may thus be formed with a height exceeding a depth of the via hole in the first insulating layer structure. This further reduces the required depth for the contact opening and the metal fill during the source/drain contact formation.

<The method further comprises:>
forming a temporary process layer over the first insulating layer structure and the source/drain body; and
forming a via opening in the first temporary process layer by etching;
wherein the via hole in the first insulating layer structure subsequently is formed by transferring the via opening into the first insulating layer structure by etching, and wherein the first temporary process layer is removed prior to forming the second insulating layer structure.

The temporary process layer may in the following be referred to using the label "first", to distinguish from a "second" temporary process layer discussed below.

Using a temporary process layer to form the via hole may facilitate the via hole formation since the material of the temporary process layer may be selected with regard to its etching and masking properties and with less regard to its suitability as a layer in the final device, e.g. its insulating properties. For instance, the source/drain body may in some embodiments be covered by a dielectric etch stop layer (liner), wherein the via opening may be formed by etching the first temporary process layer selectively to the etch stop layer.

In some embodiments, the via opening may be formed to be displaced (horizontally) relative the source/drain body such that the source/drain body is separated from the via opening by a remaining portion of the first temporary process layer.

The first temporary process layer may be an organic material layer, such as an organic planarizing layer (e.g. an organic spin-on-layer). An organic / carbon-based material may be etched with a high selectivity to typical interlayer dielectrics (ILD) and dielectric etch stop layers.

The method may further comprise forming an contact etch stop layer (liner) covering the first insulating layer structure and the source/drain body, wherein the method further may comprise opening the etch stop layer over the buried wiring line prior to forming the via hole, and opening the etch stop layer on the source/drain body prior to forming the source/drain contact.

In some embodiments, the metal via may be formed by selective deposition of metal in the via hole in the first insulating layer structure.

This enables a bottom-up deposition of metal in the via hole, allowing void-free filling of the via hole and a precise control of a height dimension of the metal via. Additionally, the need for a subsequent metal recess or etch-back is obviated since the metal is deposited selectively at the position of the via hole. The deposition of metal may be stopped when the upper via portion protrudes by a desired amount above the via hole.

Forming the metal comprises depositing metal in the via hole and in the via opening, and wherein the method further comprises removing the first temporary process layer subsequent to forming the metal via.

The metal is accordingly deposited without first removing the first temporary process layer. This enables forming of a metal via / prefill with an increased vertical dimension since the via opening, in addition to the via hole, may act as a template for the metal deposition. As may be appreciated, this reduces the required depth of the contact opening subsequently formed in the second insulating layer structure. The metal deposition may be a selective deposition (i.e. bottom-up) as discussed above, or a top-down deposition followed by a metal recess to remove overburden metal (i.e. deposited outside the via opening).

The metal via is formed such that the upper portion protrudes above a level of the source/drain body.

In some embodiments, the method may further comprise, prior to forming the second insulating layer structure:
forming a second temporary process layer covering the upper via portion and the source/drain body;
patterning the second temporary process layer to form a dummy contact block on the upper via portion and the source/drain body;
wherein the second insulating layer structure may be formed to embed the dummy contact block, and wherein the contact opening may be formed by removing the dummy contact block selectively to the second insulating layer structure.

The contact opening may hence be formed in a tone-inverted fashion, wherein the dummy contact block may be replaced with the source/drain contact (e.g. a "replacement metal contact process").

The second temporary process layer may be an organic material layer. An organic / carbon-based material may be etched with a high selectivity to typical ILDs and dielectric etch stop layers. The second temporary process layer may for instance be an organic planarizing layer.

In some embodiments the second insulating layer structure may be formed to embed and cover the dummy contact block; wherein a sacrificial gate may be formed across the at least one channel layer prior to forming the source/drain body, and wherein the method may further comprise, while the second insulating layer structure covers the dummy contact block, replacing the sacrificial gate with a metal gate.

The dummy contact block (which as mentioned above may be organic and hence be sensitive to elevated process temperatures) may accordingly be masked from the process conditions (typically involving elevated process temperatures) during the replacement metal gate (RMG) process. Forming the metal gate prior to forming the source/drain contact may additionally reduce a risk of a degraded source/drain contact-body interface.

In some embodiments, the second insulating layer structure may be formed to cover the upper via portion and the source/drain body, and wherein the contact opening may be formed by etching the second insulating layer structure to expose the source/drain body and the upper via portion.

In some embodiments, a sacrificial gate may be formed across the at least one channel layer prior to forming the source/drain body, and wherein the method may further comprise replacing the sacrificial gate with a metal gate subsequent to forming the second insulating layer structure and prior to forming the contact opening. The source/drain body and the metal via may accordingly be masked from the process conditions (typically involving elevated process temperatures) during the replacement metal gate (RMG) process. Forming the metal gate prior to forming the source/drain contact may additionally reduce a risk of a degraded source/drain contact-body interface.

### Brief description of the drawings

The above, as well as additional objects, features and advantages, may be better understood through the following illustrative and non-limiting detailed description, with reference to the appended drawings. In the drawings like reference numerals will be used for like elements unless stated otherwise.
Figures 1-10 schematically illustrate a method for interconnecting a buried wiring line and a source/drain body.
Figures 11-15 schematically illustrate a further method.
Figures 16-17 schematically illustrate a further method.
Figures 18-19 schematically illustrate a method according to an embodiment.
Figures 20-21 schematically illustrate a replacement metal gate process according to an embodiment.

### Detailed description

Hereafter follows a detailed description of embodiments of a method for forming a semiconductor device, more specifically for forming an interconnection between a buried wiring line and a source/drain body, e.g. a source/drain body of a FET transistor device. The FET transistor device may comprise at least one horizontally oriented channel layer. Examples of applicable FET devices include the finFET device (e.g. comprising a single fin-shaped channel layer) and the horizontal/lateral nanowire- or nanosheet-channel FET device (e.g. comprising a number of vertically stacked nanowires or nanosheets). While reference in the following will be made mainly to a buried wiring line in the form of a BPR, it is to be noted that the method is equally applicable to also other types of buried wiring lines, such as buried interconnect lines, buried routing lines, or buried inter-cell signal lines for memory or logic applications.

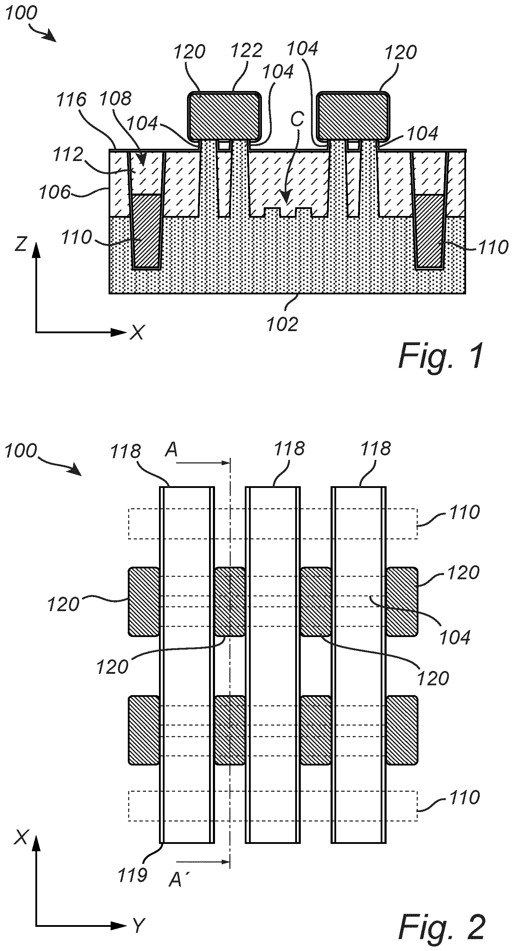

Figs. 1-2 show a preliminary device structure 100 wherein Fig. 1 is a cross-section taken along line A-A' indicated in the top-down view of Fig. 2. The device structure 100 comprises a substrate 100. The substrate 102 may be a conventional semiconductor substrate suitable for CMOS processing. The substrate 101 may be a single-layered semiconductor substrate, for instance formed by a bulk substrate such as a Si substrate, a germanium (Ge) substrate or a silicon-germanium (SiGe) substrate. A multi-layered / composite substrate is however also possible, such as an epitaxially grown semiconductor layer on a bulk substrate, or a semiconductor-on-insulator (SOI) substrate, such as a Si-on-insulator substrate, a Ge-on-insulator substrate, or a SiGe-on-insulator substrate. The X- and Y-directions indicated in the figures designate first and second horizontal directions, mutually perpendicular to each other and parallel to a main plane of the substrate 102. The Z-direction designate a vertical direction normal to the main plane of the substrate 102.

The device structure 100 further comprises a number of fin structures 104 formed on the substrate 102. Each fin structure 104 forms an elongated fin-shaped structure with a longitudinal dimension oriented in Y-direction and protruding in the Z-direction from the substrate 102. A width dimension of each fin structure 104 is oriented in the X-direction. The fin structures 104 extend in parallel to each other and are spaced apart in the X-direction. While reference in the following mainly will be made to one fin structure 104, the method to be disclosed may be applied in parallel to any number of fin structures. The fin structures 104 may be formed e.g. by etching trenches in a semiconductor layer of a channel material (e.g. for forming a finFET device), or in a semiconductor layer stack of sacrificial layers of a sacrificial material and channel layers of a channel material, arranged alternatingly with each other (e.g. for forming a nanowire- or nanosheet-channel FET device). The pattern of fin structures may be etched back or cut at positions where no fin structures are desired, e.g. as exemplified in region C of Fig. 2. After forming the fin structures 104, the fin structures 104 may be surrounded by shallowtrench isolation (STI) 106, e.g. by filling the trenches with insulating material (e.g. an ILD such as SiO₂) and etching back the same to a desired height. Techniques for fin patterning and STI formation are per se well known in the art and will hence not be further discussed herein.

The device structure 100 further comprises a buried wiring line, hereinafter exemplified as a BPR 110. The BPR 110 is formed in a trench 108 extending alongside the fin structure 104 in the Y-direction. The BPR 110 may be formed by etching the trench 108 through the STI 106 and into the substrate 102. The BPR 110 may then be formed in the trench 108 by filling the trench 108 with one or more metals (e.g. a barrier metal and a fill metal) and thereafter etching back the metal to form the BPR 110 with a desired height (along the Z-direction) in the trench 108. The BPR 110 may then be capped by an insulating layer structure 112 (i.e. a "first insulating layer structure") comprising one or more insulating layers, for instance a nitride liner (e.g. SiN) and an interlayer dielectric (e.g. SiO₂). For conciseness, combined structure of the STI 106 and the first insulating layer structure 112 may in the following be denoted "lower isolation layer structure 114".

As indicated in Figs 1-2, additional BPRs may be formed in parallel to the BPR 110, alongside another one of the fin structures. While in the illustrated method, the BPR 110 is formed with a height such that the BPR 110 protrudes into a lower thickness portion of the STI 106, this is merely an example and it is also possible to form the BPR 110 with a smaller height such that the BPR 110 is embedded only within a thickness portion of the substrate 102.

The device structure 100 further comprises a number of sacrificial gate structures 118 formed across the fin structure(s) 104. Each sacrificial gate structure 118 extends in the X-direction and overlaps a respective channel region of each fin structure 104. The sacrificial gate structure(s) 118 may be formed after forming the BPR(s) 110. Each sacrificial gate structure 118 may comprise a sacrificial gate or sacrificial gate body formed by depositing a sacrificial gate layer, e.g. of a-Si, and then patterning the sacrificial gate body therein using single- or multiple-patterning techniques, as per se is known in the art. The sacrificial gate body may be provided with a gate spacer 119 (e.g. an conformally deposited nitride such as SiN deposited by atomic layer deposition, ALD) formed to extend along sidewalls of each sacrificial gate body. Furthermore, a gate cap (omitted from Fig. 2), e.g. of a hard mask material, may be provided on top of the sacrificial gate body. Further details of forming sacrificial gate structures is per se well known in the art and will hence not be further discussed herein.

The device structure 100 further comprises source/drain bodies 120 for each FET device, formed by epitaxy at either side of each sacrificial gate structure 118 (and channel region). The source/drain bodies 120 may be doped in accordance with the intended conductivity type of the FET devices to be formed, e.g. using in-situ doping techniques. Each source/drain body 120 is formed on, i.e. in contact with, the one or more channel layer of a respective fin structure 104. Source/drain bodies 120 on neighboring fin structures 104 may as shown be formed to merge to form common source/drain bodies for the neighboring fin structures 104.

The source/drain bodies 120 may as shown subsequently be covered by an etch stop layer 122, e.g. a dielectric etch stop layer or liner (e.g. an ALD-deposited SiN) for protecting the source/drain bodies 120 during subsequent processing steps.

Prior to the epitaxy, the fin structures 104 may be recessed by etching back the fin structures 104 in a top-down direction (e.g. negative Z) at either side of each sacrificial gate structure, while using the sacrificial gate structure as an etch mask. Each fin structure 104 may thereby be partitioned into a plurality of fin structure portions, each comprising one or more channel layer portions preserved in the channel region underneath each sacrificial gate 118. The etch back may thus define end surfaces of the (respective) channel layer(s) at either side of each sacrificial gate structure 118 on which the source/drain bodies 120 may be grown. The sacrificial gate structures 118 may prior to the fin recess and the forming of the source/drain bodies 120 be surrounded by ILD (e.g. SiO₂). Source/drain trenches may then be etched in the ILD at locations where fin structures 104 are to be recessed and the source/drain bodies 120 are to be formed. Accordingly, the view in Fig. 1 may correspond to a cross section taken along a source/drain trench.

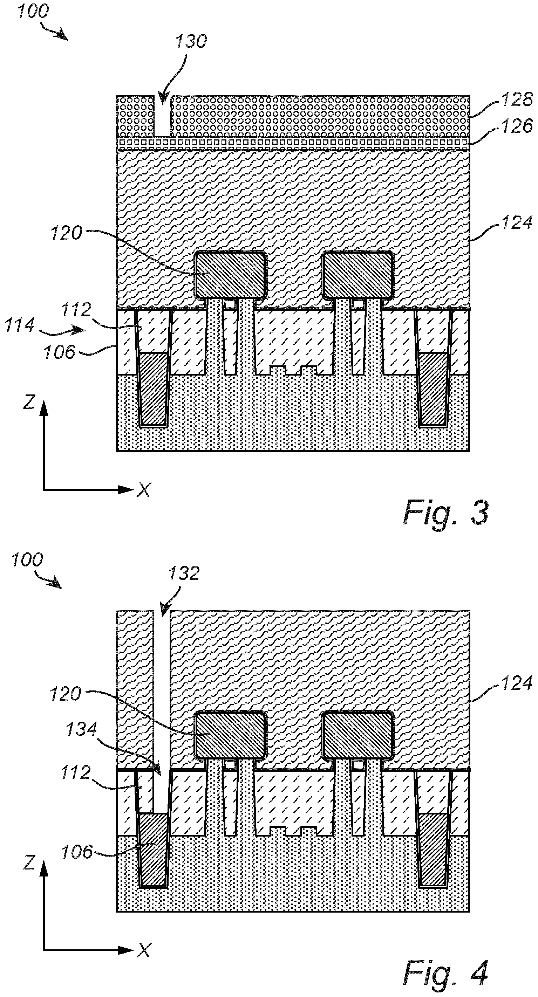

Figs. 3-5 illustrate process steps for forming a via hole 134 in the first insulating layer structure 112 to expose an upper surface of the buried wiring line 110.

In Fig. 3 a (first) temporary process layer 124 has been formed over the lower isolation layer structure 114 and the source/drain bodies 120. The temporary process layer 124 may be an organic material layer such as an organic planarizing layer deposited by chemical vapor deposition (CVD) or by spin-on-deposition (e.g. a spin-on-carbon layer). More generally, the temporary process layer 124 may however be formed by any material facilitating the patterning process to be described below and presenting a sufficient etch contrast with respect to the materials of the lower isolation layer structure 114.

A photoresist layer 128 and one or more underlayers 126 (e.g. a spin-on-glass layer) have further been formed over the temporary process layer 124. An opening 130 has been patterned in the photoresist layer 128, e.g. by lithography. In Fig. 4, the opening 130 has been transferred by etching into the temporary process layer 124 (thus forming via opening 132 therein) and subsequently into the first insulating layer structure 112, thereby forming the via hole 134. The etching may be stopped on the upper surface of the BPR 110. An anisotropic etching process, for instance a dry etching process such as reactive ion etching (RIE), may be used. As may be appreciated, the transfer of the opening 130 into the first insulating layer structure 112 may comprise a sequence of etch steps with different etching chemistries suitable for etching the different materials of e.g. the temporary process layer 124, the etch stop layer 122 and of the first insulating layer structure 112.

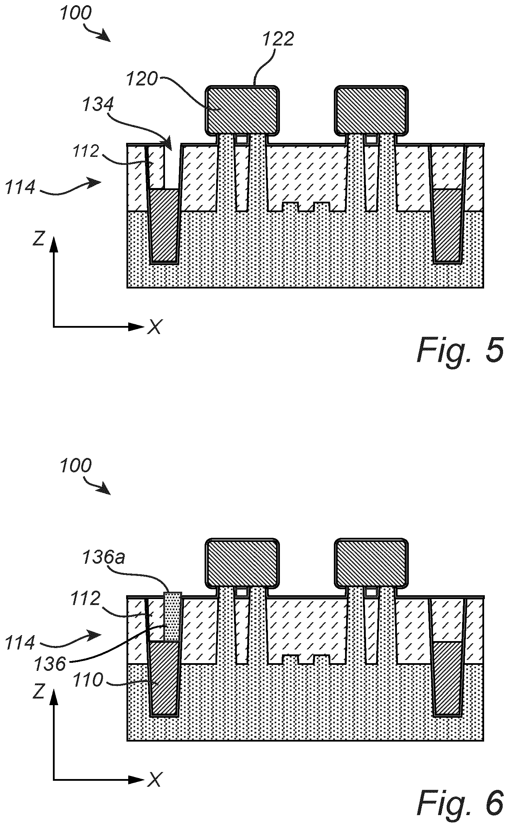

In Fig. 5, the temporary process layer 124 has been removed from the device structure 100, e.g. using a suitable etching process, such as a plasmabased dry etch.

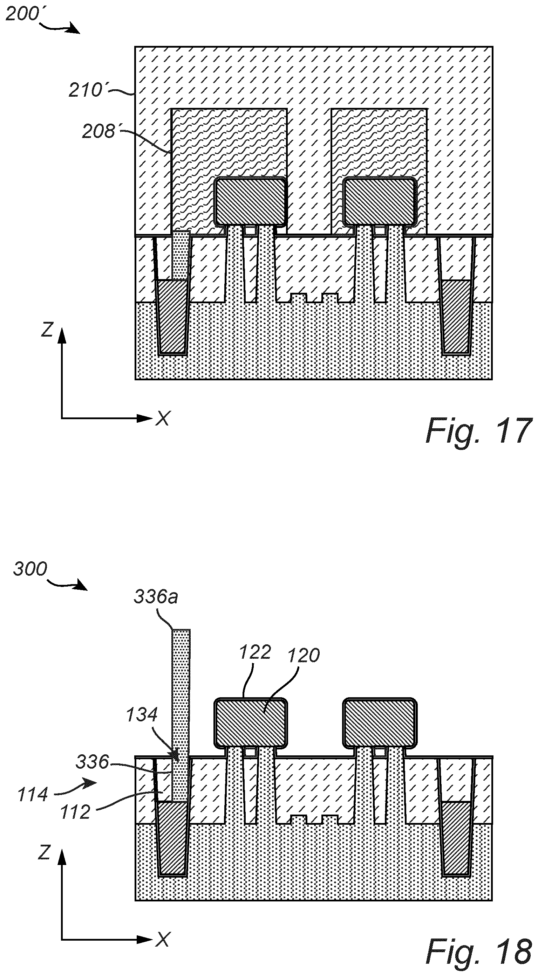

In the following, various ways to form the via will be described. Figs 18-19 illustrate formation of the via wherein the metal via is formed such that the upper portion protrudes above a level of the source/drain body, as defined in the claims. Figs 6-17 may be seen as examples useful for understanding the invention. Process steps discussed in conjunction with Figs 6-17 may be combined with the process steps of Figs 18-19, as understood by the skilled person.

In Fig. 6 a metal via / "prefill" 136 has been formed in the via hole 134, on the exposed upper surface of the BPR 110. The metal via 136 may be formed by area selective deposition (ASD) of metal in the via hole 134. Various processes for ASD are possible.

In one example, ASD of prefill metal by ALD or electro-less deposition (ELD) adapted to seed from the exposed metal surface of the BPR 110 may be used. Examples of suitable prefill metals include e.g. Ru or Co. ELD, or synonymously electro-less plating or auto-catalytic plating, enables a "bottom-up" deposition of a metal on a metal surface (e.g. the BPR 110), wherein the metal surface acts as an electrode and catalyst for a reduction of metal ions to form the metal material. The metal ions may be dissolved in a solution, e.g. an aqueous solution comprising a reducing agent.

In another example, for improved area selectivity, the metal deposition may be preceded by a functionalization of the exposed surface of the BPR 110 and/or sidewalls of the via hole 134. For instance, a seed layer may be deposited selectively by ALD on the exposed surface of the BPR 110, to facilitate subsequent seeding of ALD- or ELD-deposited prefill metal. Alternatively, a treatment step such as a short etch step (e.g. a H₂ plasma etch) may be applied to increase a hydrophilicity or hydrophobicity of the exposed surface of the BPR 110 and/or sidewalls of the via hole 134 relative exposed surfaces outside the via hole 134. Alternative a treatment step including a selective deposition of a self-assembled monolayer (SAM) on the BPR 110 and/or sidewalls of the via hole 134 may be applied. For example, the SAM may have a hydrophobic tail group and a head group adapted to bond to the exposed surface of the BPR 110 and/or the sidewalls of the via hole 134, but not to exposed surfaces outside the via hole 134 (e.g. the etch stop layer 122. The tail group may meanwhile be adapted to act as a seed for a subsequent deposition of the prefill metal (e.g. by ALD).

The metal via 136 may as shown be formed with a height exceeding a depth (as seen along the Z-direction) of the via hole 134, such that an upper via portion 136a of the metal via 136 protrudes above the via hole 134 and the first insulating layer structure 112 (as well an upper surface of the lower isolation layer structure 114). This is however merely an option and it is also possible to form the metal via 136 to only partially fill a depth of the via hole 134.

While in the figures, a metal via 136 is formed only on a BPR 110 adjacent one source/drain body 120, it is to be understood that a corresponding metal via may be formed adjacent any number of source/drain bodies in parallel.

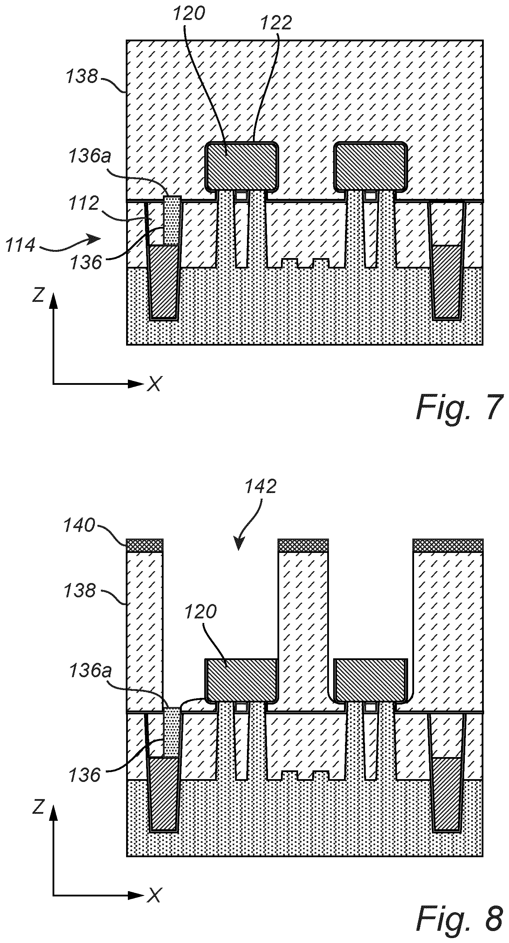

In Fig. 7, a (second) insulating layer structure 138 has been formed over the device structure 100, to cover the metal via 136 and the lower isolation layer structure 114 and the source/drain bodies 120 (and the etch stop layer 122 if present). The insulating layer structure 138 may be formed by a layer of ILD (e.g. SiO₂ deposited by CVD), but may also be a composite layer structure of two or more insulating layers of different materials such as a dielectric liner (e.g. a nitride such as SiN) followed by a layer of ILD (e.g. SiO₂). As may be understood from the afore-going discussion, the sacrificial gate structures 118 shown in Fig. 2 may hence again be surrounded by ILD (e.g. the source/drain trenches may be re-filled). The insulating layer structure 138 may further be subjected to chemical mechanical polishing (CMP) to planarize an upper surface of the insulating layer structure 138.

In Fig. 8 a contact opening 142 has been formed in the (second) insulating layer structure 138 by etching to expose the source/drain body 120 and the upper via portion 136a of the metal via 136. An additional short etch step (e.g. an isotropic nitride etch) may be applied to open the etch stop layer 122 on the source/drain bodies 120, if present. The contact opening 142 may be formed in a lithography-and-etching process, e.g. comprising lithographically defining a contact opening pattern in a resist layer, and transferring the pattern into lower layers of a lithographic layer stack, e.g. comprising a hard mask 140 and further an organic planarizing layer (e.g. spin-on-carbon) and a spin-on-glass layer (omitted from Fig. 8 for illustrational clarity). The contact opening pattern may subsequently be transferred into the insulating layer structure 138. Any suitable conventional combination of etching processes (e.g. wet and/or dry) and etching chemistries may be used to form the contact opening 142.

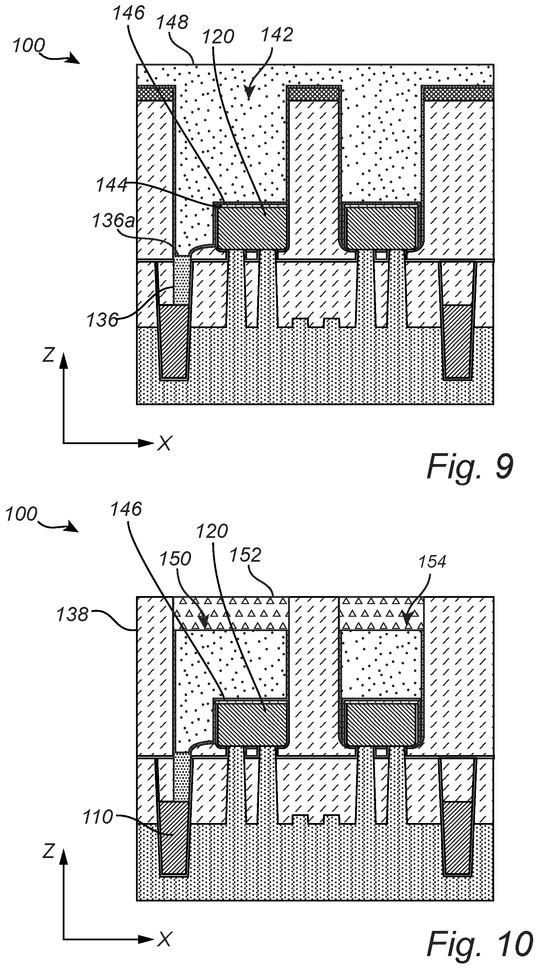

Figs. 9-10 show forming of a source/drain contact 150 in the contact opening 148, on the upper via portion 136a and the source/drain body 120, thereby interconnecting the BPR 110 and the source/drain body 120.

The forming of the source/drain contact 150 may as depicted comprise depositing one or more contact metals in the contact opening 148, such as a barrier metal 146 (e.g. TiN) and a contact fill metal 148 (e.g. W, Cu, Al) respectively deposited using e.g. ALD, CVD or physical vapor deposition (PVD). An overburden of contact metal may subsequently be removed by a planarization and/or metal etch back process, such as CMP.

The deposition of contact metal may be preceded by forming a contact silicide 144 on the source/drain bodies 120. Silicide formation may be done using conventional techniques, e.g. by depositing a suitable metal (such as Ti) followed by anneal to trigger silicidation. After anneal, non-silicided metal may be removed by a metal etch (e.g. isotropic, wet or dry).

As shown in Fig. 10, the contact formation may proceed by recessing the deposited contact metal to form a final source/drain contact 150 of a desired height.

The openings in the insulating layer structure 138 may as shown be filled or "plugged" with an insulating material, e.g. by an ILD such as CVD-deposited SiO₂, thereby capping the source/drain contact 150 with insulating material. The insulating material may be deposited and then planarized, e.g. by CMP, to arrive at the device structure 100 in Fig. 10.

As further shown in Fig. 10, additional source/drain contacts 154 may be formed on source/drain bodies in adjacent contact openings. In the illustrated example, the source/drain contact 154 is however not formed in contact with any BPR but merely contacts the respective source/drain body. Accordingly, a source/drain contact 150 interconnecting a BPR 110 and a source/drain body 120 may be formed in parallel to a "conventional" source/drain contact 154 merely forming a contact for a source/drain body.

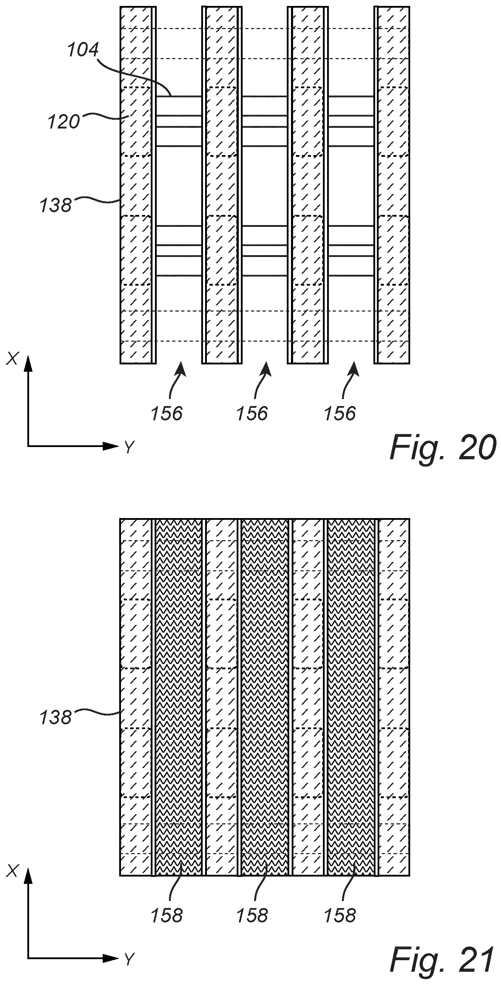

The method as set out above may further be supplemented with a replacement metal gate (RMG) process to replace the sacrificial gate bodies of the sacrificial gate structures 118 shown in Fig. 2 with functional gate stacks (e.g. comprising metal gates) in each channel region. The RMG process may be performed after the stage of the method shown in Fig. 7, i.e. after forming (and planarizing) the (second) insulating layer structure 138 and prior to forming the contact opening 142. Fig. 20 is a representative schematic top-down view of the device structure 100 at this stage of the method wherein, additionally, the sacrificial gate structures 118 (e.g. the gate cap and the sacrificial gate body) have been removed by etching, thereby forming gate trenches 156 in the insulating layer structure 138, extending across and exposing the fin structure(s) 104 in the respective channel regions.

In Fig. 21, a functional gate stack 158 has been deposited in the gate trenches 156, to overlap the respective channel regions. The gate stack 158 may comprise a gate dielectric layer and a gate metal stack comprising one or more effective a work function metal (WFM) layers and a gate fill metal. The gate dielectric layer may be formed of a conventional a high-k dielectric e.g. HfO₂, HfSiO, LaO, AlO or ZrO. The WFM layer may be formed of one or more effective WFMs (e.g. an n-type WFM such as TiAl or TiAlC and/or a p-type WFM such as TiN or TaN). The gate fill metal may be formed of conventional gate fill metals e.g. W, Al, Co or Ru. The gate dielectric layer and the first WFM may be deposited by ALD. The gate fill metal may for instance be deposited by CVD or PVD. The gate stack may after deposition be recessed using a metal etch-back process to provide the functional gate stacks 158 with a desired vertical dimension and then be covered by a gate cap, e.g. of a nitride such as SiN. The method may thereafter proceed in accordance with Fig. 8 and onwards by forming the contact opening 142.

As will be appreciated by a skilled person, an overall method for forming a FET device may include additional process steps in dependence on particular type of device that is to be formed. For instance, a method for forming a horizontal/lateral nanowire- or nanosheet-channel FET device (e.g. comprising a number of vertically stacked nanowires or nanosheets) with a wrap-around gate or gate-all-around may additionally comprise a "channel release process". In a channel release process, sacrificial layers arranged alternatingly with channel layers of each fin structure 104 may be removed in the channel regions by etching, within the gate trenches 156, the sacrificial material selectively to the channel material. Thereby the channel layers may be "released", such that the functional gate stack 158 may be subsequently deposited in each gate trench 156 to surround the channel layers.

Furthermore, to facilitate among the "channel release", process steps may be performed for forming so-called "inner spacers" on end surfaces of the sacrificial layers, after fin recess and prior to source/drain body epitaxy. Inner spacer formation generally comprises, as per se is known in the art, laterally recessing (i.e. etching back along the +Y and -Y directions) the sacrificial layers from both sides of each sacrificial gate 118 using an isotropic etching process selective to the sacrificial material, and filling the recesses with an inner spacer material (e.g. an ALD-deposited oxide, nitride or carbide). Spacer material deposited outside the recesses may be removed by a subsequent etch step. The inner spacers may thus, among others, act as an etch mask for the source/drain bodies 120 during the channel release.

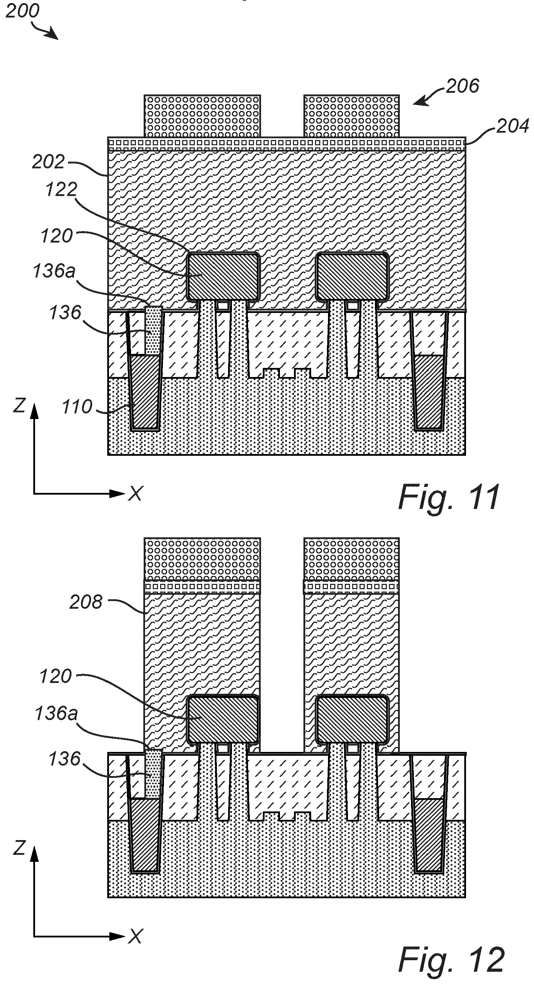

Figs 11-15 schematically illustrate a method for interconnecting a buried wiring line and a source/drain body.

The method initially proceeds as shown and disclosed with reference to Figs 1-6 above. The device structure 200 shown in Fig. 11 hence corresponds to the device structure 100 shown in Fig. 7, however, in contrast to the preceding method, after forming the metal via 136, the method proceeds by forming a (second) temporary process layer 202 covering the upper via portion 136a and the source/drain body 120 (or source/drain bodies in the source/drain trench). The second temporary process layer 202 may be like the first temporary process layer 124 be an organic material layer, such as a spin-on-carbon layer.

In Fig. 12, the second temporary process layer 202 has been patterned to form a dummy contact block 208 on the upper via portion 136a and the source/drain body 120. The second temporary process layer 202 may like the first temporary process layer 124 be patterned using a lithography and etching process. As shown in Fig. 11, a photoresist layer 206 and one or more underlayers 204 (e.g. a spin-on-glass layer) may be formed over the second temporary process layer 202. The contact block pattern may be patterned in the photoresist layer 128, e.g. by lithography, and subsequently transferred into the underlayer(s) 204 and then the second temporary process layer 202.

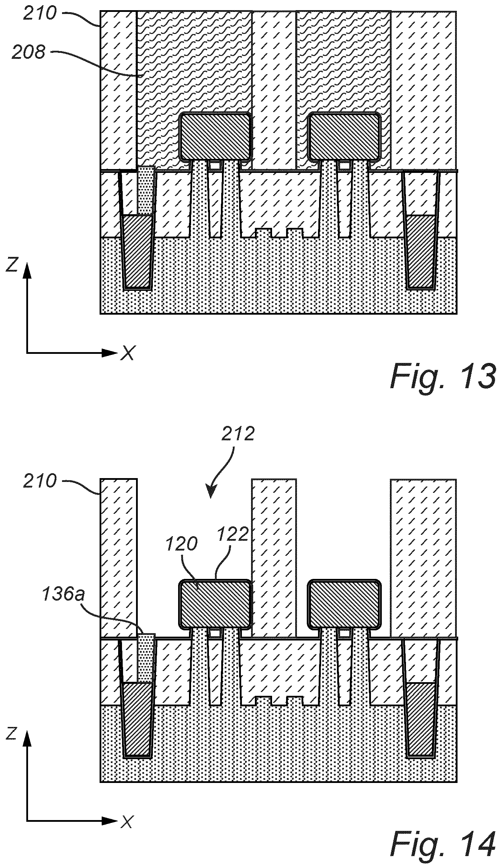

In Fig. 13, a second insulating layer structure 210 corresponding to the second insulating layer structure 138 (e.g. an ILD layer such as SiO₂) has been formed to embed the dummy contact block 208. The second insulating layer structure 210 has further been planarized and/or etched back to expose an upper surface of the dummy contact clock 208.

In Fig. 14, a contact opening 212 corresponding to the contact opening 142 has been formed by removing the dummy contact block 208 selectively to the second insulating layer structure 210, thereby exposing the upper via portion 136a and the source/drain body 120 (or the etch stop layer 122 thereon, if present).

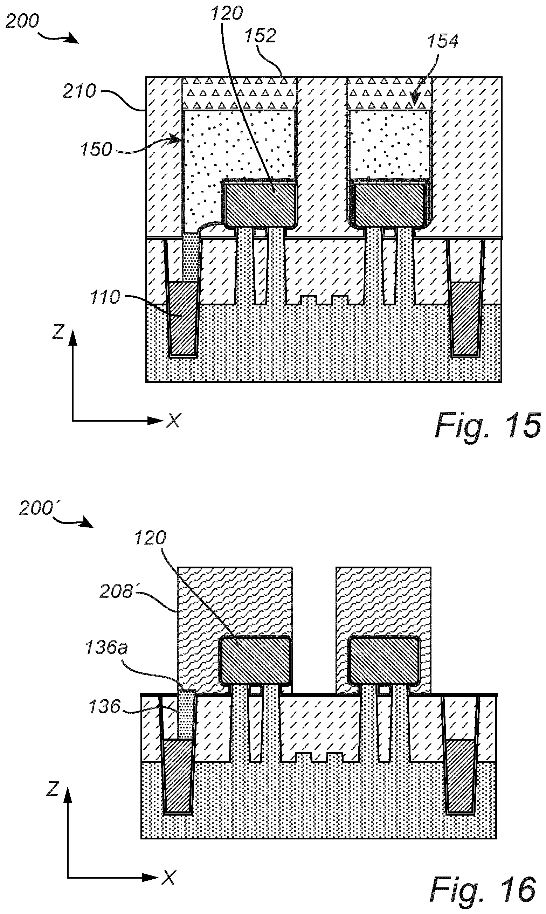

Fig. 15 shows the device structure 200 after completing the forming of the source/drain contact 154 and capping the same with insulating material 152.

Similar to the preceding method, the present method may further be supplemented with an RMG process, e.g. after completing the forming of the source/drain contact 154. The RMG process may otherwise proceed in a corresponding manner as set out above and will hence not be repeated here.

Figs 16-17 schematically illustrate a method for interconnecting a buried wiring line and a source/drain body according to a further embodiment. The method as shown in Figs 16-17 differs from the method shown in Figs 11-15 in that after forming the dummy contact block 208 as shown in Fig. 12, the dummy contact block 208 is recessed (e.g. by an anisotropic top-down etch back) to form a recessed dummy contact block 208' on the upper via portion 136a and the source/drain body 120. Fig. 16 shows the resulting device structure 200'.

In Fig. 17, a second insulating layer structure 210' corresponding to the second insulating layer structure 210 has subsequently been formed to embed and cover the recessed dummy contact block 208'.

The method may thereafter proceed by forming an opening in the second insulating layer structure to expose an upper surface of the recessed dummy contact block 208' (e.g. using a lithography-and-etching process). The dummy contact block 208' may then be removed to form a corresponding to contact opening 212 in Fig. 14, and forming a source/drain contact corresponding to 150 therein as shown in Fig. 15. The contact opening may be formed by removing the recessed dummy contact block 208' selectively to the second insulating layer structure by etching from the opening in the second insulating layer structure 210'.

One merit of this approach is that an amount of dummy contact block material which needs to be removed to form the contact opening may be reduced. This may reduce the exposure of e.g. the upper via portion 136a and the source/drain body 120 to the etching chemistry.

Additionally, an RMG process may be performed prior to removing the dummy contact block 208' and forming the source/drain contact. This since the recessed dummy contact block 208' may be covered and thus masked by the second insulating layer structure 210 during the RMG process.

Figs 18-19 schematically illustrate a method for interconnecting a buried wiring line and a source/drain body according to the invention.

The method proceeds as shown and disclosed with reference to Figs 1-5 above. The device structure 300 shown in Fig. 11 hence corresponds to the device structure 100 shown in Fig. 6, however, differs in that the metal via 336 is deposited after forming the via opening in the temporary process layer 124 and prior to removing the same. That is, the metal via 336 may hence be formed in the via hole 134 in the insulating layer structure 112 and in the via opening 132 in the first sacrificial process layer 124. The upper via portion 336a of the metal via 336 is hence formed in the via opening 132. In particular, as shown in Fig. 18, the metal via 336 may be formed with a height such that the upper portion 336a protrudes above a level of the source/drain body 120. The metal via 336 may be formed using any of the above-described ASD-techniques. However it is also possible to form the metal via 336 by filling the via hole 134 and the via opening 132 with metal by a (top-down) metal deposition, and thereafter removing overburden metal by a planarization and/or metal etch back process, such as CMP. The first temporary process layer 124 may subsequently be removed, thereby arriving at the device structure 300 show in Fig. 18.

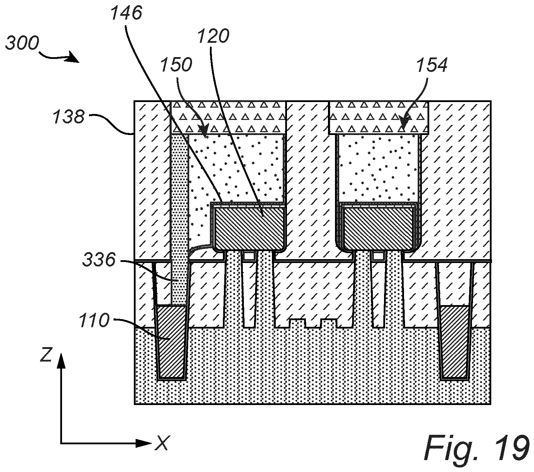

The method may thereafter proceed as shown in Fig. 19 (corresponding to Fig. 7), Fig. 20 (corresponding to Fig. 8), and Fig. 21 (corresponding to Fig. 10). The "extended height metal via 336" is however also compatible with the dummy contact formation approaches disclosed in connection with Figs 11-15 and 16-17, respectively, wherein the respective discussions of the RMG process applies correspondingly.

In the above the inventive concept has mainly been described with reference to a limited number of examples. However, as is readily appreciated by a person skilled in the art, other examples than the ones disclosed above are equally possible within the scope of the inventive concept, as defined by the appended claims. For instance, while in the above, embodiments of methods for interconnecting a buried wiring line and a source/drain body have been disclosed in conjunction with a device structure comprising sacrificial gate structures and an RMG process, it is contemplated that the method of the present invention, as set out in the appended claims, has a more general applicability and may be used also in a FET device fabrication which do not involve RMG processes.

## Claims

1. A method for interconnecting a buried wiring line (110) and a source/drain body (120), the method comprising:
forming a fin structure (104) on a substrate (102), the fin structure comprising at least one channel layer;
forming a buried wiring line in a trench (108) extending alongside the fin structure, wherein the buried wiring line is capped by a first insulating layer structure (112);
forming a source/drain body on the at least one channel layer by epitaxy;
forming a via hole (134) in the first insulating layer structure to expose an upper surface of the buried wiring line;
forming a metal via (336) in the via hole:
forming a second insulating layer structure (138) over the first insulating layer structure, wherein a contact opening (212) is defined in the second insulating layer structure to expose the source/drain body and an upper via portion (336a) of the metal via;
forming a source/drain contact (150) in the contact opening, on the upper via portion and the source/drain body, thereby interconnecting the buried wiring line and the source/drain body; the method **characterized by**
forming a first temporary process layer (124) over the first insulating layer structure and the source/drain body;
forming a via opening (132) in the first temporary process layer by etching
wherein the via hole in the first insulating layer structure subsequently is formed by transferring the via opening into the first insulating layer structure by etching, and wherein the first temporary process layer is removed prior to forming the second insulating layer structure; and
wherein forming the metal comprises depositing metal in the via hole and in the via opening, and wherein the method further comprises removing the first temporary process layer subsequent to forming the metal via; and
wherein the metal via is formed such that the upper portion protrudes above a level of the source/drain body.

2. A method according to claim 1, wherein the first temporary process layer is an organic material layer.

3. A method according to any one of the preceding claims, wherein the metal via is formed by selective deposition of metal in the via hole in the first insulating layer structure.

4. A method according to any one of the preceding claims, further comprising, prior to forming the second insulating layer structure:
forming a second temporary process layer (202) covering the upper via portion and the source/drain body;
patterning the second temporary process layer to form a dummy contact block (208) on the upper via portion and the source/drain body;
wherein the second insulating layer structure is formed to embed the dummy contact block, and wherein the contact opening is formed by removing the dummy contact block selectively to the second insulating layer structure.

5. A method according to claim 6, wherein the second temporary process layer is an organic material layer.

6. A method according to any one of claims 4-5, wherein the second insulating layer structure is formed to cover the dummy contact block; and
wherein a sacrificial gate is formed across the at least one channel layer prior to forming the source/drain body, and wherein the method further comprises, while the second insulating layer structure covers the dummy contact block, replacing the sacrificial gate with a metal gate.

7. A method according to any one of claims 1-3 wherein the second insulating layer structure is formed to cover the upper via portion and the source/drain body, and wherein the contact opening is formed by etching the second insulating layer structure to expose the source/drain body and the upper via portion.

8. A method according to claim 7, wherein a sacrificial gate is formed across the at least one channel layer prior to forming the source/drain body, and wherein the method further comprises replacing the sacrificial gate with a metal gate subsequent to forming the second insulating layer structure and prior to forming the contact opening.

9. A method according to any one of the preceding claims, wherein the buried wiring line is a buried power rail, BPR.

## Patentansprüche

1. Verfahren zur Zusammenschaltung einer vergrabenen Verdrahtungsleitung (110) und eines Source-/Drain-Körpers (120),
wobei das Verfahren umfasst:
Bilden einer Finnenstruktur (104) auf einem Substrat (102), wobei die Finnenstruktur mindestens eine Kanalschicht umfasst;
Bilden einer vergrabenen Verdrahtungsleitung in einem Graben (108), der sich entlang der Finnenstruktur erstreckt, wobei die vergrabene Verdrahtungsleitung mit einer ersten Isolierschichtstruktur (112) abgedeckt ist;
Bilden eines Source-/Drain-Körpers auf der mindestens einen Kanalschicht durch Epitaxie;
Bilden eines Durchgangslochs (134) in der ersten Isolierschichtstruktur, um eine Oberseite der vergrabenen Verdrahtungsleitung freizulegen;
Bilden einer metallischen Durchkontaktierung (336) in dem Durchgangsloch;
Bilden einer zweiten Isolierschichtstruktur (138) über der ersten Isolierschichtstruktur, wobei eine Kontaktöffnung (212) in der zweiten Isolierschichtstruktur definiert ist, um den Source-/Drain-Körper und einen oberen Durchkontaktierungsabschnitt (336a) der metallischen Durchkontaktierung freizulegen;
Bilden eines Source-/Drain-Kontakts (150) in der Kontaktöffnung, auf dem oberen Durchkontaktierungsabschnitt und dem Source-/Drain-Körper, wodurch die vergrabene Verdrahtungsleitung und der Source-/Drain-Körper zusammengeschaltet werden;
wobei das Verfahren **gekennzeichnet ist durch**
Bilden einer ersten provisorischen Prozessschicht (124) über der ersten Isolierschichtstruktur und dem Source-/Drain-Körper;
Bilden einer Durchkontaktierungsöffnung (132) in der ersten provisorischen Prozessschicht durch Ätzen,
wobei das Durchgangsloch in der ersten Isolierschichtstruktur anschließend durch Übertragen der Durchkontaktierungsöffnung in die erste Isolierschichtstruktur durch Ätzen gebildet wird, und wobei die erste provisorische Prozessschicht vor dem Bilden der zweiten Isolierschichtstruktur entfernt wird; und
wobei das Bilden des Metalls das Abscheiden von Metall in dem Durchgangsloch und in der Durchkontaktierungsöffnung umfasst, und wobei das Verfahren ferner das Entfernen der ersten provisorischen Prozessschicht nach dem Bilden der metallischen Durchkontaktierung umfasst; und
wobei die metallische Durchkontaktierung derart gebildet wird, dass der obere Abschnitt über einem Niveau des Source-/Drain-Körpers übersteht.

2. Verfahren nach Anspruch 1, wobei die erste provisorische Prozessschicht eine organische Materialschicht ist.

3. Verfahren nach einem der vorhergehenden Ansprüche, wobei die metallische Durchkontaktierung durch selektive Abscheidung von Metall in dem Durchgangsloch in der ersten Isolierschichtstruktur gebildet wird.

4. Verfahren nach einem der vorhergehenden Ansprüche, ferner umfassend, vor dem Bilden der zweiten Isolierschichtstruktur:
Bilden einer zweiten provisorischen Prozessschicht (202), die den oberen Durchkontaktierungsabschnitt und den Source-/Drain-Körper verdeckt;
Strukturieren der zweiten provisorischen Prozessschicht, um einen Dummy-Kontaktblock (208) auf dem oberen Durchkontaktierungsabschnitt und dem Source-/Drain-Körper zu bilden,
wobei die zweite Isolierschichtstruktur gebildet wird, um den Dummy-Kontaktblock einzubetten, und wobei die Kontaktöffnung durch selektives Entfernen des Dummy-Kontaktblocks von der zweiten Isolierschichtstruktur gebildet wird.

5. Verfahren nach Anspruch 6, wobei die zweite provisorische Prozessschicht eine organische Materialschicht ist.

6. Verfahren nach einem der Ansprüche 4 bis 5, wobei die zweite Isolierschichtstruktur gebildet wird, um den Dummy-Kontaktblock zu verdecken; und
wobei ein Opfer-Gate über die mindestens eine Kanalschicht vor dem Bilden des Source-/Drain-Körpers gebildet wird, und wobei das Verfahren, während die zweite Isolierschichtstruktur den Dummy-Kontaktblock verdeckt, ferner das Ersetzen des Opfer-Gates durch ein Metall-Gate umfasst.

7. Verfahren nach einem der Ansprüche 1 bis 3, wobei die zweite Isolierschichtstruktur gebildet wird, um den oberen Durchkontaktierungsabschnitt und den Source-/Drain-Körper zu verdecken, und wobei die Kontaktöffnung durch Ätzen der zweiten Isolierschichtstruktur gebildet wird, um den Source-/Drain-Körper und den oberen Durchkontaktierungsabschnitt freizulegen.

8. Verfahren nach Anspruch 7, wobei ein Opfer-Gate über die mindestens eine Kanalschicht vor dem Bilden des Source-/Drain-Körpers gebildet wird, und wobei das Verfahren ferner das Ersetzen des Opfer-Gates durch ein Metall-Gate nach dem Bilden der zweiten Isolierschichtstruktur und vor dem Bilden der Kontaktöffnung umfasst.

9. Verfahren nach einem der vorhergehenden Ansprüche, wobei die vergrabene Verdrahtungsleitung eine vergrabene Stromschiene, BPR, ist.

## Revendications

1. Procédé d'interconnexion d'une ligne de câblage enterrée (110) et d'un corps de source/drain (120),
le procédé comprenant :
la formation d'une structure à ailettes (104) sur un substrat (102 la structure à ailettes comprenant au moins une couche de canal ;
la formation d'une ligne de câblage enterrée dans une tranchée (108) s'étendant le long de la structure à ailettes, dans lequel la ligne de câblage enterrée est recouverte d'une première structure de couche isolante (112) ;
la formation d'un corps de source/drain sur au moins une couche de canal par épitaxie ;
la formation d'un trou d'interconnexion (134) dans la première structure de couche isolante afin d'exposer la surface supérieure de la ligne de câblage enterrée ;
la formation d'un trou d'interconnexion métallique (336) dans le trou d'interconnexion :
la formation d'une deuxième structure de couche isolante (138) sur la première structure de couche isolante, dans lequel une ouverture de contact (212) est définie dans la deuxième structure de couche isolante afin d'exposer le corps de source/drain et une partie de trou d'interconnexion supérieure (336a) du trou d'interconnexion métallique ;
la formation d'un contact de source/drain (150) dans l'ouverture de contact, sur la partie de trou d'interconnexion supérieure et le corps de source/drain, interconnectant ainsi la ligne de câblage enterrée et le corps de source/drain ; le procédé étant **caractérisé par** la formation d'une première couche de traitement temporaire (124) sur la première structure de couche isolante et le corps de source/drain ;
la formation d'une ouverture de trou d'interconnexion (132) dans la première couche de traitement temporaire par gravure.
dans lequel le trou d'interconnexion de la première structure de couche isolante est ensuite formé par transfert de l'ouverture de trou d'interconnexion dans la première structure de couche isolante par gravure et dans lequel la première couche de traitement temporaire est retirée avant la formation de la deuxième structure de couche isolante ; et
dans lequel la formation du métal comprend le dépôt de métal dans le trou d'interconnexion et dans l'ouverture de trou d'interconnexion et dans lequel le procédé comprend également le retrait de la première couche de traitement temporaire après la formation du trou d'interconnexion métallique ; et
dans lequel le trou d'interconnexion métallique est formé de telle sorte que sa partie supérieure dépasse d'un niveau du corps de source/drain.

2. Procédé selon la revendication 1, dans lequel la première couche de traitement temporaire est une couche de matériau organique.

3. Procédé selon une quelconque des revendications précédentes, dans lequel le trou d'interconnexion métallique est formé par dépôt sélectif de métal dans le trou d'interconnexion de la première structure de couche isolante.

4. Procédé selon une quelconque des revendications précédentes, comprenant en outre,
avant la formation de la structure de la deuxième couche isolante :
la formation d'une deuxième couche de traitement temporaire (202) recouvrant la partie supérieure du trou d'interconnexion et le corps de source/drain ;
la formation d'un motif sur la deuxième couche de traitement temporaire pour former un bloc de contact fictif (208) sur la partie supérieure du trou d'interconnexion et le corps de source/drain,
dans lequel la deuxième structure de couche isolante est formée pour intégrer le bloc de contact fictif et dans lequel l'ouverture de contact est formée en retirant le bloc de contact fictif sélectivement sur la structure de la deuxième couche isolante.

5. Procédé selon la revendication 6, dans lequel la deuxième couche de traitement temporaire est une couche de matériau organique.

6. Procédé selon une quelconque des revendications 4 à 5, dans lequel la deuxième couche isolante est formée pour recouvrir le bloc de contact fictif ; et
dans lequel une grille sacrificielle est formée au travers d'au moins une couche de canal avant la formation du corps de source/drain et dans lequel le procédé comprend en outre, tandis que la deuxième structure de couche isolante recouvre le contact fictif, le remplacement de la grille sacrificielle par une grille métallique.

7. Procédé selon une quelconque des revendications 1 à 3, dans lequel la deuxième couche isolante est formée pour recouvrir la partie supérieure du trou d'interconnexion et le corps de source/drain et dans lequel l'ouverture de contact est formée par gravure de la deuxième structure de couche isolante pour exposer le corps de source/drain et la partie supérieure du trou d'interconnexion.

8. Procédé selon la revendication 7, dans lequel une grille sacrificielle est formée au travers d'au moins une couche de canal avant la formation du corps de source/drain et dans lequel le procédé comprend en outre le remplacement de la grille sacrificielle par une grille métallique après la formation de la deuxième structure de couche isolante et avant la formation de | 'ouverture de contact.

9. Procédé selon une quelconque des revendications précédentes, dans lequel la ligne de câblage enterrée est un rail d'alimentation enterré (BPR).
